# EUROPEAN PATENT APPLICATION

(11) **EP 4 485 552 A1**
(43) Date of publication of application: **01.01.2025**
(21) Application number: 24184235.0
(22) Date of filing: 25.06.2024
(51) Int. Cl.: H01L 33/02, H01L 33/14, H01S 5/30

(54) **NITRIDE SEMICONDUCTOR LIGHT EMITTING ELEMENT AND METHOD OF MANUFACTURING SAME**

(30) Priority: 27.06.2023 JP 2023105120; 06.09.2023 JP 2023144515
(71) Applicant: Nichia Corporation, Anan-shi, Tokushima 774-8601 (JP)
(72) Inventor: OKADA, Takuya, Anan-shi, Tokushima, 774-8601 (JP)
(74) Representative: Betten & Resch

(57) **Abstract**

A nitride semiconductor light emitting element includes: an n-side semiconductor layer; a p-side semiconductor layer; and an active layer positioned between the n-side semiconductor layer and the p-side semiconductor layer. The active layer includes, successively from a n-side semiconductor layer side: a first barrier layer containing Al and an n-type impurity, a first well layer containing Al and emitting ultraviolet light, a second barrier layer containing Al, and a second well layer containing Al and emitting ultraviolet light. A highest n-type impurity concentration peak in the first barrier layer is located in a portion of the first barrier layer that is closer to the p-side semiconductor layer than to the n-side semiconductor layer. An Al composition ratio of the first barrier layer is higher than an Al composition ratio of the second barrier layer.

## Description

### CROSS-REFERENCE TO RELATED APPLICATION

This application claims priority to Japanese Patent Application No. 2023-105120 filed on June 27, 2023, and Japanese Patent Application No. 2023-144515 filed on September 6, 2023, the disclosures of which are hereby incorporated by reference in their entireties.

### TECHNICAL FIELD

The present disclosure relates to a nitride semiconductor light emitting element and a method of manufacturing the same.

### BACKGROUND

The development of a nitride semiconductor light emitting element that emits ultraviolet light has been in progress. For example, Japanese Patent Publication No. H09-153645 discloses a light emitting element having an emission layer that emits ultraviolet light.

### SUMMARY

There is room for improvement in terms of the light emission output of a nitride semiconductor light emitting element that emits ultraviolet light as compared to a light emitting element that emits visible light.

One object of the present disclosure is to provide a nitride semiconductor light emitting element that emits ultraviolet light with an improved light emission output and a method of manufacturing the same.

A nitride semiconductor light emitting element according to the present disclosure is a light emitting element comprising an n-side semiconductor layer, a p-side semiconductor layer, and an active layer positioned between the n-side semiconductor layer and the p-side semiconductor layer, wherein
the active layer includes, successively from the n-side semiconductor layer side, a first barrier layer containing Al and an n-type impurity, a first well layer containing Al and emitting ultraviolet light, a second barrier layer containing Al, and a second well layer containing Al and emitting ultraviolet light,
the highest n-type impurity concentration peak in the first barrier layer is located closer to the p-side semiconductor layer, and
the Al composition ratio of the first barrier layer being higher than the Al composition ratio of the second barrier layer.

A method of manufacturing a nitride semiconductor light emitting element according to the present disclosure includes:
forming an n-side semiconductor layer;
forming an active layer above the n-side semiconductor layer; and
forming a p-side semiconductor layer above the active layer, wherein
the step of forming an active layer includes:
   forming above the n-side semiconductor layer a first barrier layer by growing above the n-side semiconductor layer a first layer containing Al and an n-type impurity followed by growing above the first layer a second layer containing Al and a higher concentration n-type impurity than that of the first layer;
   forming above the first barrier layer a first well layer containing Al and emitting ultraviolet light;
   forming above the first well layer a second barrier layer containing Al and an n-type impurity and having a lower Al composition ratio than the Al composition ratio of the first layer and the Al composition ratio of the second layer; and
   forming above the second barrier layer a second well layer containing Al and emitting ultraviolet light.

According to an embodiment of the present disclosure a high output nitride semiconductor light emitting element which emits ultraviolet light and a method of manufacturing the same can be provided.

### BRIEF DESCRIPTION OF THE DRAWINGS

FIG. 1 is a cross-sectional view showing the constituents of a nitride semiconductor light emitting element according to one embodiment of the present disclosure.
FIG. 2 is a diagram showing the structure of the active layer and the electron blocking layer of the nitride semiconductor light emitting element shown in FIG. 1.
FIG. 3 is a cross-sectional view showing an underlayer formed above the upper face of a substrate in a method of manufacturing a light emitting element according to one embodiment of the present disclosure.
FIG. 4 is a cross-sectional view showing a superlattice layer formed above the underlayer shown in FIG. 3 in the method of manufacturing a light emitting element according to the embodiment of the present disclosure.
FIG. 5 is a cross-sectional view showing an n-side semiconductor layer formed above the superlattice layer shown in FIG. 4 in the method of manufacturing a light emitting element according to the embodiment of the present disclosure.
FIG. 6 is a cross-sectional view showing an active layer formed above the n-side semiconductor layer shown in FIG. 5 in the method of manufacturing a light emitting element according to the embodiment of the present disclosure.
FIG. 7 is a cross-sectional view showing an electron blocking layer formed above the active layer shown in FIG. 6 in the method of manufacturing a light emitting element according to the embodiment of the present disclosure.
FIG. 8 is a cross-sectional view showing a p-side semiconductor layer formed above the electron blocking layer shown in FIG. 7 in the method of manufacturing a light emitting element according to the embodiment of the present disclosure.
FIG. 9 is a top view of a specific example of a nitride semiconductor light emitting element according to an embodiment of the present disclosure.
FIG. 10 is a cross-sectional view taken along line X-X in FIG. 9.

### DETAILED DESCRIPTION

Certain embodiments and examples of the present disclosure will be explained below with reference to the accompanying drawings. The light emitting elements and the methods of manufacturing light emitting elements described below are provided to give shape to the technical ideas of the present disclosure, and do not limit the invention unless otherwise specifically stated.

In the drawings, the same reference numerals denote members having the same functions. To make the features easily understood, the descriptions of the features are distributed among the embodiments and examples, but the constituent elements described in different embodiments can be replaced or combined in part. The explanation of common features already described in embodiments appearing earlier might be omitted in the subsequent embodiments where the explanation is focused only on the differences. The same or similar effects attributable to the same or similar features, in particular, will not be mentioned each time an embodiment or example is discussed. The sizes of and positional relationships between the members shown in each drawing might be exaggerated for clarity of explanation. For example, the drawings accompanying the present specification are primarily schematic diagrams showing the stacked structures, and do not necessarily accurately reflect the thickness of each layer.

### EMBODIMENT

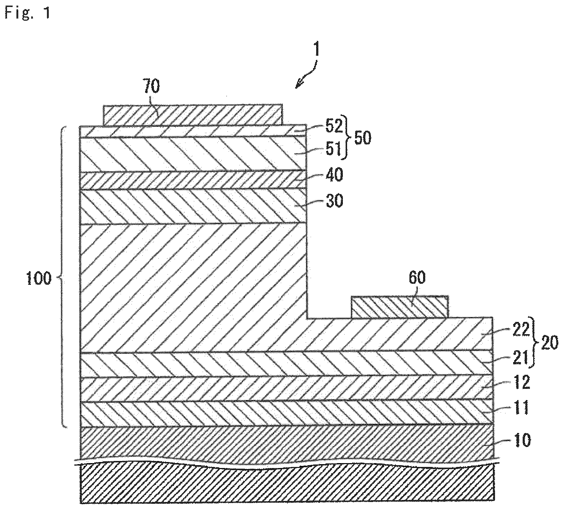

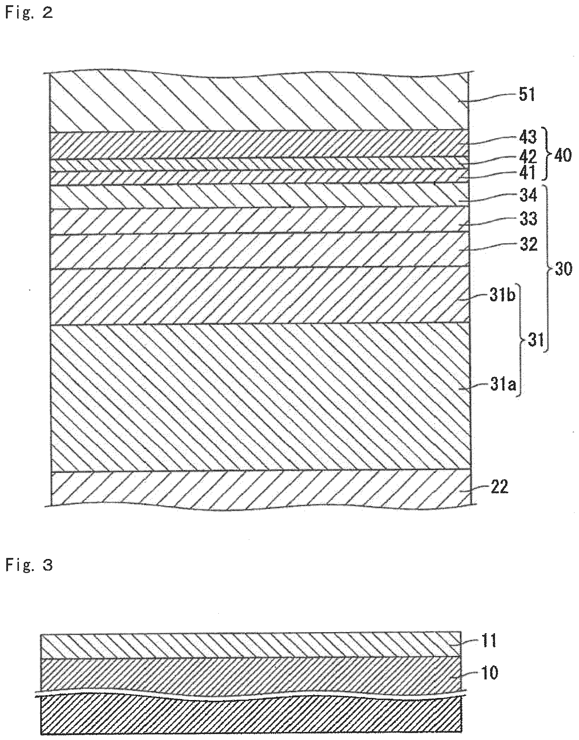

FIG. 1 is a schematic cross-sectional view of a nitride semiconductor light emitting element 1 according to an embodiment. FIG. 2 is a schematic cross-sectional view enlarging the active layer 30 and the electron blocking layer 40 that are parts of a semiconductor structure body 100.

As shown in FIG. 1 and FIG. 2, the nitride semiconductor light emitting element 1 has a substrate 10 and a semiconductor structure body 100 disposed above the substrate 10. The semiconductor structure body 100 includes an n-side semiconductor layer 20, a p-side semiconductor layer 50, and an active layer 30 positioned between the n-side semiconductor layer 20 and the p-side semiconductor layer 50 and emitting ultraviolet light, each formed of a nitride semiconductor. The semiconductor structure body 100 also includes an underlayer 11 and a superlattice layer 12 positioned between the substrate 10 and the n-side semiconductor layer 20, and an electron blocking layer 40 positioned between the active layer 30 and the p-side semiconductor layer 50. The nitride semiconductor light emitting element 1 has an n-electrode 60 electrically connected to the n-side semiconductor layer 20 and a p-electrode 70 electrically connected to the p-side semiconductor layer 50.

The active layer 30 includes, successively from the n-side semiconductor layer 20 side, a first barrier layer 31 containing Al and an n-type impurity, a first well layer 32 containing Al and emitting ultraviolet light, a second barrier layer 33 containing Al, and a second well layer 34 containing Al and emitting ultraviolet light, in which the highest n-type impurity concentration peak in the first barrier layer 31 is located closer to the p-side semiconductor layer 50.

The Al composition ratio of the first barrier layer 31 is higher than the Al composition ratio of the second barrier layer 33.

According to the nitride semiconductor light emitting element described above, the light emission efficiency of the first well layer 32 can be improved, increasing the ultraviolet light emission output as described in detail later.

In other words, the nitride semiconductor light emitting element according to this embodiment was created to achieve a high ultraviolet light emission output by focusing on the room for improvement in the light emission efficiency of the well layer located closer to the n-side semiconductor layer 20 than to the p-side semiconductor layer 50 in a nitride semiconductor light emitting element having a multiple quantum well structure and emitting ultraviolet light, and increasing the light emission efficiency in the well layer that is located closer to the n-side semiconductor layer 20.

The substrate 10 and each semiconductor layer will be specifically described below.

For the material for the substrate 10, for example, sapphire, silicon (Si), gallium nitride (GaN), aluminum nitride (AIN), or the like can be used. A substrate 10 formed of sapphire is preferable, as it has a high transmittance with respect to the ultraviolet light from the active layer 30. The semiconductor structure body 100 can be disposed, for example, above C-plane of the sapphire substrate, and is preferably disposed above a face oblique to the C-plane of the sapphire substrate forming a 0.2 to 2 degree angle with the a-axis or the m-axis of the sapphire substrate. The thickness of the substrate 10 can be set, for example, in a range of 150 µm to 800 µm. The nitride semiconductor light emitting element 1 does not have to have a substrate 10.

A semiconductor structure body 100 is a stack structure in which nitride semiconductor layers are stacked. The nitride semiconductor can be any semiconductor obtained by varying the composition ratio x and y within their ranges in the chemical formula InₓAl_{y}Ga_{1-x-y}N (0≤x≤1, 0≤y≤1, x+y≤1).

For an underlayer 11, for example, a layer formed of AIN can be used. The underlayer 11 functions to reduce lattice mismatch between the substrate 10 and the nitride semiconductor layers disposed above the underlayer 11. The thickness of the underlayer 11 can be set, for example, in a range of 0.5 µm to 4 µm, preferably 1.5 µm to 4 µm. The underlayer 11 may include a buffer layer, and the buffer layer is located near the surface of the substrate 10. In the present specification, the thickness of each semiconductor layer refers to the thickness in the stacking direction of the semiconductor structure body 100.

A superlattice layer 12 may be, for example, a multilayer structure in which first semiconductor layers and second semiconductor layers having a different lattice constant from that of the first semiconductor layers are alternately formed. The superlattice layer 12 has the function of reducing the stress occurring in the semiconductor layers disposed above the superlattice layer 12. The superlattice layer 12 can be a multilayer structure in which AlN layers and aluminum gallium nitride (AlGaN) layers are alternately stacked. The number of pairs of first and second semiconductor layers in the superlattice layer 12 can be set to 20 to 50 pairs. In the case in which the first semiconductor layers are AlGaN and the second semiconductor layers are AIN layers, for example, the first semiconductor layer can be 5 nm to 30 nm in thickness, and the second semiconductor layer can be 5 nm to 30 nm in thickness.

An n-side semiconductor layer 20 includes one or more n-type semiconductor layers. Examples of n-type semiconductor layers include semiconductor layers containing an n-type impurity, such as silicon (Si), germanium (Ge), or the like. An n-type semiconductor layer is, for example, an AlGaN layer containing aluminum (Al), gallium (Ga), and nitrogen (N), and may contain indium (In). For example, the n-type impurity concentration of an n-type semiconductor layer containing Si as an n-type impurity is in a range of 5 × 10¹⁸ /cm³ to 1 × 10²⁰ /cm³. The n-side semiconductor layer 20 has only to have the function of supplying electrons to the active layer 30, and may include an undoped layer. Here, an undoped layer is a layer not intentionally doped with an n-type impurity or a p-type impurity. In the case where an undoped layer is adjacent to a layer intentionally doped with an n-type impurity and/or a p-type impurity, the undoped layer might contain the n-type impurity and/or the p-type impurity diffused from the adjacent layer.

As shown in FIG. 1, the n-side semiconductor layer 20 includes, for example, an undoped layer 21 and an n-side contact layer 22. The undoped layer 21 is disposed between the superlattice layer 12 and the n-side contact layer 22. The n-side contact layer 22 is disposed between the undoped layer 21 and the active layer 30.

For the undoped layer 21, for example, an undoped AlGaN layer can be used. In the case of using an AlGaN layer as the undoped layer 21, the Al composition ratio of the AlGaN layer can be set, for example, in a range of 25% to 70%.

For the n-side contact layer 22, for example, a layer formed of AlGaN and containing an n-type impurity can be used. In the case of using an AlGaN layer as the n-side contact layer, the Al composition ratio of the AlGaN layer can be set, for example, to 25% to 70%. In the present specification, an AlGaN layer having an Al composition ratio of 50%, for example, means that the composition ratio x in the chemical formula Al_{X}Ga_{1-X}N is 0.5. The n-type impurity concentration of the n-side contact layer 22 can be set, for example, in a range of 5 × 10¹⁸ /cm³ to 1 × 10²⁰ /cm³. The thickness of the n-side contact layer 22 is preferably greater than the thickness of the undoped layer 21. Making the n-side contact layer 22 thicker than the undoped layer 21 can reduce the forward voltage increase. The thickness of the n-side contact layer 22 can be set, for example in a range of 1.5 µm to 4 µm. The n-side contact layer 22 has an upper face above which no semiconductor layer is disposed. An n-electrode 60 is disposed above a portion of the upper face of the n-side contact layer 22 above which no semiconductor layer is disposed.

An active layer 30 is disposed between an n-side semiconductor layer 20 and a p-side semiconductor layer 50. The active layer 30 emits ultraviolet light. The peak emission wavelength of the ultraviolet light emitted by the active layer 30 is in a range of, for example, 220 nm to 350 nm.

The active layer 30 includes, successively from the n-side semiconductor layer 20 side, a first barrier layer 31 containing Al and an n-type impurity, a first well layer 32 containing Al and emitting ultraviolet light, a second barrier layer 33 containing Al, and a second well layer 34 containing Al and emitting ultraviolet light. Here, the first barrier layer 31 and the second barrier layer 33 both contain Al. The highest n-type impurity concentration peak in the first barrier layer 31 is located closer to the p-side semiconductor layer 50. Moreover, the Al composition ratio of the first barrier layer 31 is higher than the Al composition ratio of the second barrier layer 33. This can increase the light emission efficiency in the first well layer 32. In other words, in this embodiment, the number of holes injected into the first well layer 32 can be increased by making the band gap of the second barrier layer 33 smaller than the band gap of the first barrier layer 31 by making the Al composition ratio of the first barrier layer 31 higher than the Al composition ratio of the second barrier layer 33. Because the band gap of the first barrier layer 31 is larger than the band gap of the second barrier layer 33, the hole trapping effect in the first well layer 32 can be increased. For example, the Al composition ratio of the first barrier layer 31 is 3% to 17% greater than the Al composition ratio of the second barrier layer 33. This can increase the light emission efficiency in the first well layer 32. In this embodiment, the hole trapping effect in the first well layer 32 is further improved by increasing the difference between the band gap of the first barrier layer 31 and the band gap of the first well layer 32 in the valence band by positioning the n-type impurity concentration peak in the first barrier layer 31 closer to the p-side semiconductor layer 50. This can further increase the light emission efficiency in the first well layer 32. There is a concern that doping the first barrier layer 31 with an n-type impurity could degrade the crystallinity of the first barrier layer 31. In this embodiment, however, the barrier at the border between the first well layer 32 and the first barrier layer 31 is made higher while reducing the n-type impurity concentration in the first barrier layer 31 closer to the n-side semiconductor layer 20 by positioning the highest n-type impurity concentration peak in the first barrier layer 31 closer to the p-side semiconductor layer 50. This can reduce the crystallinity deterioration of the first barrier layer 31 as a whole. Here, the highest n-type impurity concentration peak in the first barrier layer 31 positioned closer to the p-side semiconductor layer 50 is, for example, 1 × 10¹⁹ to 6×10¹⁹/cm³. Furthermore, the lowest n-type impurity concentration in the first barrier layer 31 is located closer to the n-side semiconductor layer 20 than the highest n-type impurity concentration peak in the first barrier layer 31 is. For example, the lowest n-type impurity concentration in the first barrier layer 31 is 1 × 10¹⁷ to 9x 10¹⁷/cm³.

Specific examples and preferable examples of barrier layers and well layers in this embodiment will be described below.

For example, a first barrier layer 31 has a first layer 31a and a second layer 31b that is located closer to the p-side semiconductor layer 50 than the first layer 31a is as shown in FIG. 2. The n-type impurity concentration of the first layer 31a differs from the n-type impurity concentration of the second layer 31b. Specifically, the first layer 31a contains the n-type impurity at the concentration lower than the average value of the n-type impurity concentration in the entirety of the first barrier layer 31, and the second layer 31b contains the n-type impurity at the concentration higher than the average value of n-type impurity concentration in the entirety of the first barrier layer 31. Allowing the first barrier layer 31 to have a first layer 31a and a second layer 31b having different n-type impurity concentrations in this manner can locate the highest n-type impurity concentration in the first barrier layer 31 closer to the p-side semiconductor layer 50. The highest n-type impurity concentration peak in the first barrier layer 31 is located in the first layer 31a, and the lowest n-type impurity concentration in the first barrier layer 31 is located in the second layer 31b.

Here, the second layer 31b is preferably lesser in thickness than the first layer 31a. The second layer 31b contains the n-type impurity concentration higher than the average value of n-type impurity concentration in an entirety of the first barrier layer 31. Thus, reducing the thickness of the second layer 31b having a relatively high n-type impurity concentration can reduce the crystallinity deterioration of the first barrier layer 31 attributable to a high n-type impurity concentration layer having a large thickness, thereby improving the light emission efficiency. For example, the thickness of the second layer 31b is preferably 5% to 30% of the thickness of the entire first barrier layer 31. This can reduce the crystallinity deterioration of the first barrier layer 31 while improving the hole trapping effect in the first well layer 32.

Moreover, the second barrier layer 33 is preferably lesser in thickness than the second layer 31b. This can increase the supply of holes to the first well layer 32.

The second barrier layer 33 may be undoped, or contain an n-type impurity. Employing an undoped second barrier layer 33 can reduce the crystallinity deterioration of the active layer 30. Allowing the second barrier layer 33 to contain an n-type impurity can reduce the electrical resistance of the second barrier layer 33 to thereby reduce the forward voltage. When the second barrier layer 33 contains an n-type impurity, the n-type impurity concentration of the second barrier layer 33 is preferably lower than the n-type impurity concentration of the second layer 31b and higher than the n-type impurity concentration of the first layer 31a. This can reduce the forward voltage while reducing the crystallinity deterioration of the second barrier layer 33.

Furthermore, the Al composition ratio of the first layer 31a and the Al composition ratio of the second layer 31b are preferably practically the same. This can reduce the band gap difference attributable to the difference between the Al composition ratio of the first layer 31a and that of the second layer 31b, allowing electrons to be supplied to the first well layer 32 efficiently.

Moreover, the first barrier layer 31 is preferably in contact with the n-side semiconductor layer 20, and the Al composition ratio of the first barrier layer 31 substantially the same as the Al composition ratio of the n-side semiconductor layer 20. This can reduce the band gap difference attributable to the Al composition ratio difference between the n-side semiconductor layer 20 and the first barrier layer 31, thereby allowing electrons to be supplied to the first well layer 32 efficiently.

In the case in which the n-side semiconductor layer 20 includes an n-side contact layer 22, and the first barrier layer 31 is in contact with the n-side contact layer 22, the n-type impurity concentration of the n-side contact layer 22 is preferably lower than n-type impurity concentration of the second layer 31b and higher than the n-type impurity concentration of the first layer 31a. This can reduce the resistance of the n-side contact layer 22 while reducing the crystallinity deterioration of the n-side contact layer 22.

The second well layer 34 is preferably lesser in thickness than the first well layer 32. This can increase the supply of holes to the first well layer 32.

The Al composition ratio of the second well layer 34 may be higher than the Al composition ratio of the first well layer 32. As described later, the Al composition ratio of an electron blocking layer 40 is preferably higher than the Al composition ratio of a barrier layer in order to reduce electron overflow. However, in the case in which the Al composition ratio of the layer, that is in contact with the second well layer 34, among the electron blocking layer 40 is high, for example, the second well layer 34 can occasionally be strained to increase the wavelength of the light emitted by the second well layer 34. By making the Al composition ratio of the second well layer 34 higher than the Al composition ratio of the first well layer 32 thereby increasing the band gap of the second well layer 34, the increase in the wavelength of the light from the second well layer 34 can be lessened. The Al composition ratio of the second well layer 34 can be 2% to 10% greater than the Al composition ratio of the first well layer 32.

For the first well layer 32 and the second well layer 34, for example, a layer formed of AlGaN can be used. For the first barrier layer 31 and the second barrier layer 33, for example, a layer formed of AlGaN can be used. The Al composition ratio of the first well layer 32 and the second well layer 34 can be set, for example, to 10% or higher, specifically 10% to 50%, more specifically 30% to 50%. Assuming that the peak wavelength of the light from the first well layer 32 and the second well layer 34 is about 280 nm, an AlGaN layer having about 42% Al composition ratio can be used for the first well layer 32 and the second well layer 34. The Al composition ratio of the first barrier layer 31 and the second barrier layer 33 can be set, for example, to 10% or higher, specifically 10% to 70%, more specifically 30% to 70%.

The thickness of the first well layer 32 can be set, for example, in a range of 3 nm to 6 nm. The thickness of the second well layer 34 can be set, for example, in a range of 1 nm to 4 nm, preferably less than the thickness of the first well layer 32 as descried above. The thickness of the first layer 31a of the first barrier layer 31 is 10 nm to 60 nm, and the thickness of the second layer 31b is 5 nm to 20 nm, for example. The thickness of the second barrier layer 33 is, for example, 1 nm to 5 nm.

Specific examples and preferable examples of barrier layers and well layers have been described above. The thickness and the Al composition ratio of and the amount of an n-type impurity added to the first layer 31a and second layer 31b of the first barrier layer 31 and the second barrier layer 33 can be suitably adjusted based on the aimed specifications, such as the emission wavelength, light emission output, drive voltage, current, and the like, by taking into consideration the specific examples and preferable examples described above. Similarly, the thickness and the Al composition ratio of and the amount of an n-type impurity added to the first well layer 32 and the second well layer 34, or the like can also be preferably adjusted by taking into consideration the specific examples and preferable examples described above.

An electron blocking layer 40 is provided to reduce the overflow of electrons supplied from the n-side semiconductor layer 20. The electron blocking layer 40 can be a multilayer structure including multiple semiconductor layers containing Al. For example, the electron blocking layer 40 can be a multilayer structure having, successively from the active layer 30 side, an AlN layer 41, a first AlGaN layer 42, and a second AlGaN layer 43 as shown in FIG. 2. For example, the Al composition ratio of the first AlGaN layer 42 can be set lower than the Al composition ratio of the second AlGaN layer 43. For example, moreover, the Al composition ratio of the first AlGaN layer 42 can be set lower than the Al composition ratio of the second AlGaN layer 43 but higher than the Al composition ratios of the first well layer 32 and the second well layer 34. The electron blocking layer 40 preferably includes an AlGaN layer having a higher Al composition ratio than the Al composition ratios of the first barrier layer 31 and the second barrier layer 33. This can reduce electron overflow. For the electron blocking layer 40, for example, an undoped first AlGaN layer 42, an undoped second AlGaN layer 43, and an undoped AlN layer 41 can be used. The total thickness of the electron blocking layer 40 can be set, for example, in a range of 4 nm to 15 nm.

A p-side semiconductor layer 50 preferably has a high transmittance with respect to the light from the first well layer 32 and the second well layer 34. For example, the p-side semiconductor layer 50 preferably includes an AlGaN layer having a higher Al composition ratio than the Al composition ratios of the first well layer 32 and the second well layer 34. However, an AlGaN layer having a high Al composition ratio has a larger band gap than that of a GaN layer or the like. For this reason, employing an AlGaN layer having a high Al composition ratio as a p-side semiconductor layer 50 tends to result in inadequate conversion of the p-side semiconductor layer 50 into a p-type layer or an increased contact resistance between the p-electrode 70 and the p-side semiconductor layer 50. Thus, for a nitride semiconductor light emitting element using an AlGaN layer having a relatively high Al composition ratio as the first well layer 32 and the second well layer 34, it is necessary to achieve both high light extraction efficiency and low forward voltage. This embodiment makes it possible to achieve a nitride semiconductor light emitting element 1 with high light extraction efficiency and low forward voltage by employing the p-side semiconductor layer 50 described below.

For example, in this embodiment, the p-side semiconductor layer 50 includes, as shown in FIG. 1, a first p-side semiconductor layer 51 and a second p-side semiconductor layer 52. Here, the first p-side semiconductor layer 51 is a layer containing a p-type impurity such as magnesium (Mg) and having a high Al composition ratio, and the second p-side semiconductor layer 52 is a layer containing a p-type impurity such as magnesium (Mg) and having a low Al composition ratio, or containing no Al (e.g., GaN layer). Including such a first p-side semiconductor layer 51 and a second p-side semiconductor layer 52 can achieve a nitride semiconductor light emitting element 1 having high light extraction efficiency and low forward voltage.

Furthermore, the first p-side semiconductor layer 51 and the second p-side semiconductor layer 52 may be of a single layer or one including multiple layers. For example, the first p-side semiconductor layer 51 may include, successively from the active layer 30 side, a first layer formed of AlGaN, a second layer formed of AlGaN with a lower Al composition ratio than that of the first layer, and a third layer formed of AlGaN with a lower Al composition ratio than that of the second layer. In this case, the third layer may be a gradient composition layer in which the Al composition ratio gradually decreases. The second p-side semiconductor layer 52 may include, for example, from the first p-side semiconductor layer 51 side, a fourth layer formed of AlGaN and a fifth layer formed of GaN. Including first to fifth layers as described above can achieve a nitride semiconductor light emitting element 1 having higher light extraction efficiency and lower forward voltage.

An n-electrode 60 is disposed above the n-side contact layer 22 and electrically connected to the n-side semiconductor layer 20. A p-electrode 70 is disposed above the second p-side semiconductor layer 52 of the p-side semiconductor layer 50 and electrically connected to the p-side semiconductor layer 50.

For the n-electrode 60, for example, metals, such as Ag, Al, Ni, Au, Rh, Ti, Pt, Mo, Ta, W, and Ru, or alloys containing these metals as main components can be used. The n-electrode 60 can be a multilayer structure including, successively from the n-side contact layer 22 side, a Ti layer, an Al alloy layer, a Ta layer, and a Ru layer, for example.

For the p-electrode 70, for example, the same or similar metal to that for the n-electrode 60 described above can be used. In the case of allowing the p-electrode 70 to have the function to reflect the light from the active layer 30 that is advancing to the p-electrode 70 towards the n-side semiconductor layer 20, the metal layer among those in the p-electrode 70 that is disposed in contact with the third layer 53 is preferably formed of a metal having a high reflectance with respect to the light from the active layer 30. For example, the metal layer preferably has, for example, a reflectance of 70% or higher, more preferably 80% or higher, with respect to the light from the active layer 30. For such a metal layer, for example, a Rh layer or Ru layer is preferably used. The p-electrode 70 can be a multilayer structure that includes, for example, a Rh layer, an Au layer, a Ni layer, and a Ti layer, or a multilayer structure that includes a Ru layer, an Au layer, a Ni layer and a Ti layer.

When a forward voltage is applied across the n-electrode 60 and the p-electrode 70, a forward voltage applies across the p-side semiconductor layer 50 and the n-side semiconductor layer 20, supplying holes and electrons to the active layer 30 to thereby allow the active layer 30 to emit light.

With respect to this embodiment, as shown in FIG. 2, a specific example in which barrier layers and well layers each included two layers have been described, but the present invention is not limited to this. For example, one, two, or more barrier layers and well layers may be disposed between the first well layer 32 and the second well layer 34.

A method of manufacturing a nitride semiconductor light emitting element according to this embodiment will be explained below with reference to FIG. 3 to FIG. 8.

A method of manufacturing a nitride semiconductor light emitting element according to this embodiment includes:
(S1) forming an n-side semiconductor layer;
(S2) forming an active layer above the n-side semiconductor layer; and
(S3) forming a p-side semiconductor layer above the active layer, in which the step of forming an active layer (S2) includes:
   (S2-1) forming above the n-side semiconductor layer a first barrier layer by growing a first layer containing Al and an n-type impurity followed by growing above the first layer a second layer containing Al and an n-type impurity having a higher concentration than a concentration of the first layer;
   (S2-2) forming above the first barrier layer a first well layer containing Al and emitting ultraviolet light;
   (S2-3) forming above the first well layer a second barrier layer containing Al and an n-type impurity where an Al composition ratio of the second barrier layer is lower than an Al composition ratio of the first layer and an Al composition ratio of the second layer, and
   (S2-4) forming above the second barrier layer a second well layer containing Al and emitting ultraviolet light.

First, as shown in FIG. 3, an underlayer 11 formed of AlN is formed above C-plane of a substrate 10 formed of sapphire, for example. The underlayer 11 is formed, for example, by MOCVD (metalorganic chemical vapor deposition), sputtering, or the like. Here, the step of forming an underlayer 11 may include a step of forming a buffer layer. For example, an underlayer 11 is formed by forming an AIN buffer layer by sputtering, and forming an AIN layer above the buffer layer by MOCVD or the like.

The semiconductor layers described later can be epitaxially grown by MOCVD, for example.

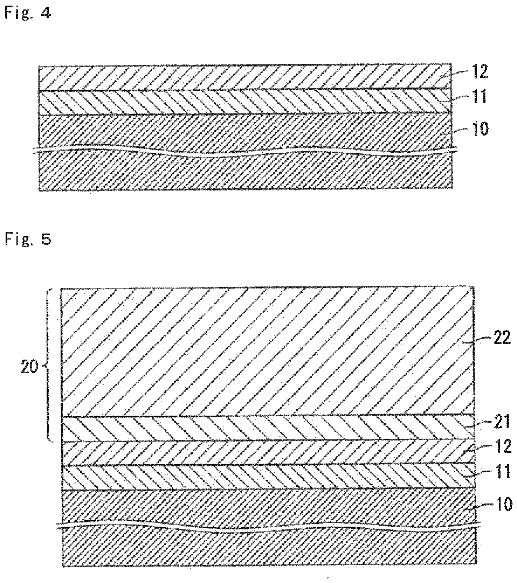

Then as shown in FIG. 4, a superlattice layer 12 is formed above the underlayer 11. The superlattice layer 12 is formed by alternately growing first semiconductor layers and second semiconductor layers having a different lattice constant from that of the first semiconductor layers. The first semiconductor layers are formed by growing AlN layers by using as the source gases a trimethyl aluminum (TMA) gas and ammonia gas, and primarily hydrogen (H₂) gas as the carrier gas, for example. The second semiconductor layers are formed by growing AlGaN layers by using as the source gases a TMA gas, a trimethyl gallium (TMG) gas, and ammonia gas, and primarily hydrogen gas as the carrier gas. Each layer of the superlattice layer 12 can be formed by setting the temperature in a range of 1000°C to 1250°C, for example.

Then as shown in FIG. 5, above the superlattice layer 12, an n-side semiconductor layer 20 which includes an undoped layer 21 and an n-side contact layer 22 is formed. The undoped layer 21 is formed by growing an AlGaN layer by using as the source gases a TMA gas, TMG gas, and ammonia gas, and primarily hydrogen gas as the carrier gas. The n-side contact layer 22 is formed by growing an AlGaN layer containing an n-type impurity by using as the source gases a TMA gas, TMG gas, and ammonia gas, a monosilane (SiH₄) gas as the n-type impurity gas, and primarily hydrogen gas as the carrier gas. Each layer of the n-side semiconductor layer 20 can be formed by setting the temperature in a range of 1000°C to 1250°C, for example.

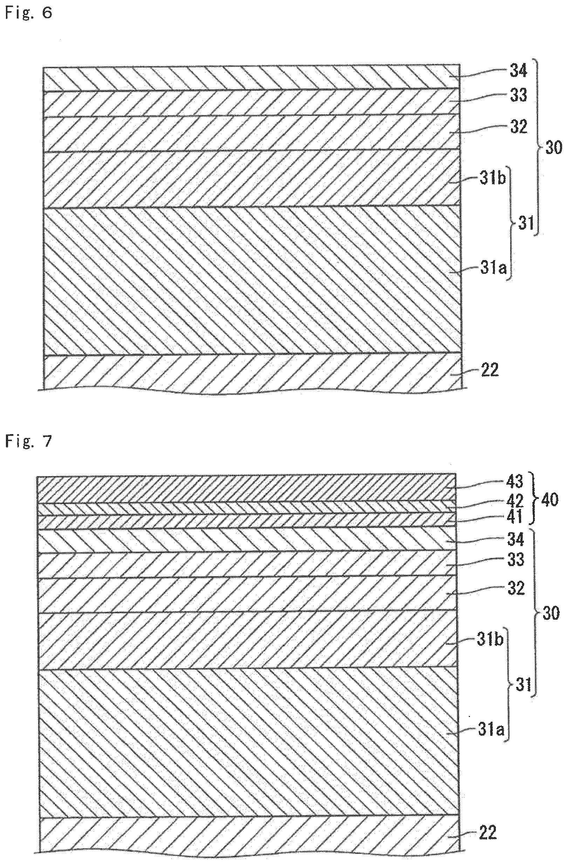

Then as shown in FIG. 6, above the n-side semiconductor layer 20, an active layer 30 which includes a first barrier layer 31 including a first layer 31a and a second layer 31b, a first well layer 32, a second barrier layer 33, and a second well layer 34 is formed. The first barrier layer 31 is formed by growing an AlGaN layer containing Si which is an n-type impurity by using as the source gases a TMA gas, TEGa gas, and ammonia gas, a monosilane (SiH₄) gas as the n-type impurity gas, and primarily nitrogen gas as the carrier gas.

Here, in the step of forming a first barrier layer 31 (S2-1), after forming a first layer 31a containing Al and an n-type impurity above the n-side semiconductor layer by using the source gases described above, the flow rate of the monosilane (SiH₄) gas is increased to form above the first layer 31a a second layer 31b containing Al and a higher concentration n-type impurity than that of the first layer 31a.

The first well layer 32 is formed by growing an AlGaN layer by using as the source gases a TMA gas, TEGa gas, and ammonia gas, and primarily nitrogen gas as the carrier gas, for example.

The second barrier layer 33 is formed by growing an AlGaN layer by using as the source gases a TMA gas, TEGa gas, and ammonia gas, and primarily nitrogen gas as the carrier gas, for example. In forming the second barrier layer 33, no n-type impurity gas is used, or the flow rate of the n-type impurity gas is set lower than the flow rate of the n-type impurity gas used in the step of forming a first barrier layer 31.

For example, the second well layer 34 is formed in the same or similar manner to the first well layer 32. The second well layer 34 is preferably formed to be lesser in thickness than the first well layer 32. Furthermore, in forming the second well layer 34, the flow rate of the TMA gas is set lower than that in the step of forming a first well layer 32 such that the Al composition ratio of the second well layer 34 is lower than the Al composition ratio of the first well layer 32.

Then as shown in FIG. 7, an electron blocking layer 40 is formed above the active layer 30. The electron blocking layer 40 is formed to include an AlN layer 41, a first AlGaN layer 42, and a second AlGaN layer 43. The AlN layer 41 of the electron blocking layer 40 is formed by using as the source gases a TMA gas and ammonia gas, and primarily nitrogen gas as the carrier gas, for example. The first AlGaN layer 42 of the electron blocking layer 40 is formed by using as the source gases a TMA gas, TEGa gas, and ammonia gas, and nitrogen gas as the carrier gas, for example: The second AlGaN layer 43 of the electron blocking layer 40 is formed by using as the source gases a TMA gas, TEGa gas, and ammonia gas, and primarily nitrogen gas as the carrier gas, for example. For example, in forming the second AlGaN layer 43, the flow ratio of the TMA gas which is the Al source gas is set higher than that in forming the first AlGaN layer 42. This can form the second AlGaN layer 43 to have a higher Al composition ratio than that of the first AlGaN layer 42. Each layer of the electron blocking layer 40 can be formed by setting the temperature in a range of 750°C to 950°C, for example.

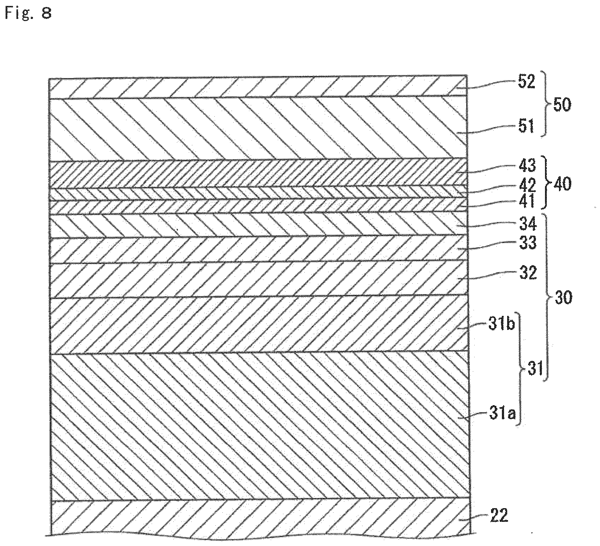

Then as shown in FIG. 8, a p-side semiconductor layer 50 is formed above the electron blocking layer 40. The p-side semiconductor layer 50 is formed by growing, successively from the active layer 30 side, a first p-side semiconductor layer 51 and a second p-side semiconductor layer 52. The first p-side semiconductor layer 51 is formed by growing an AlGaN layer containing Mg as a P-type impurity by using as the source gases a TMA gas, TEGa gas, and ammonia gas, and a bis(cyclopentadienyl)magnesium (Cp₂Mg) gas as the p-type impurity gas. The second p-side semiconductor layer 52 is formed by growing, for example, an AlGaN layer containing Mg as a p-type impurity by using as the source gases a TMA gas, TMG gas, and ammonia gas, and a bis(cyclopentadienyl)magnesium (Cp₂Mg) gas as the p-type impurity gas, or a GaN layer containing Mg as a p-type impurity by using as source gases a TMG gas and ammonia gas (no TMA gas), and a bis(cyclopentadienyl)magnesium (Cp₂Mg) gas as the p-type impurity gas.

Each layer of the p-side semiconductor layer 50 can be formed by setting the temperature in a range of 750°C to 950°C, for example.

Subsequent to forming the p-side semiconductor layer 50, a portion of the p-side semiconductor layer 50, a portion of the electron blocking layer 40, and a portion of the active layer 30 are removed to expose a portion of the n-side contact layer 22.

Then as shown in FIG. 1 an n-electrode 60 is formed above the exposed n-side contact layer 22, and a p-electrode 70 is formed above the third layer 53 of the p-side semiconductor layer 50.

By following the steps described above, a nitride semiconductor light emitting element according to this embodiment can be manufactured.

A specific form of a nitride semiconductor light emitting element according to this embodiment will be described below.

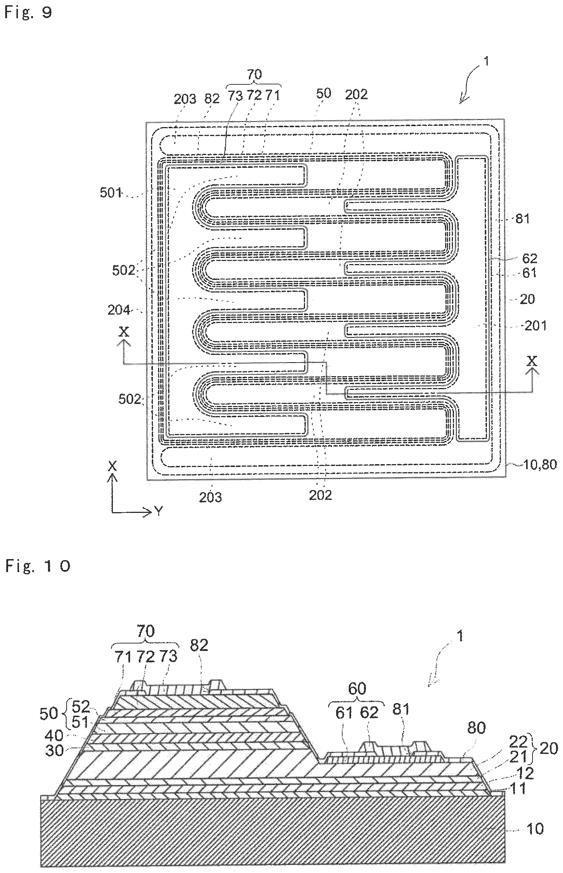

FIG. 9 is a top view of the nitride semiconductor light emitting element 1, showing the positional relationship between the n-side semiconductor layer 20 and the p-side semiconductor layer 50 in the top view, and the electrodes respectively disposed above the n-side semiconductor layer 20 and the p-side semiconductor layer 50. As shown in FIG. 9, the shape of the nitride semiconductor light emitting element 1 in the top view is quadrangular.

A preferable positional relationship between the n-side semiconductor layer 20 and the p-side semiconductor layer 50 in the nitride semiconductor light emitting element 1 in the top view, and an example of a layout of the electrodes disposed above the n-side semiconductor layer 20 and the p-side semiconductor layer 50 in the positional relationship will be described below.

As shown in FIG. 9, in the top view, the p-side semiconductor layer 50 has a base portion 501 extending in the first direction X, and multiple extended portions 502 extending from the base portion 501 in the second direction Y that is orthogonal to the first direction X. The exposed portions of the n-side semiconductor layer 20 exposed from the p-side semiconductor layer 50 include a first exposed portion 201 extending in the first direction X, four second exposed portions 202 extending from the first exposed portion 201 in the second direction Y, two third exposed portions 203 extending from the first exposed portion 201 in the second direction Y, and a fourth exposed portion 204 extending in the first direction X. Each second exposed portion 202 is positioned between two extended portions 502 of the p-side semiconductor layer 50. In the first direction X, the four second exposed portions 202 are located between the two third exposed portions 203. The third exposed portions 203 connect the first exposed portion 201 and the fourth exposed portion 204. The fourth exposed portion 204 connects the two third exposed portions 203. Here, the first exposed portion 201 is disposed along a side of the nitride semiconductor light emitting element 1 that extends in the first direction X. The fourth exposed portion 204 is disposed along the side of the nitride semiconductor light emitting element 1 that opposes the side extending along the first exposed portion 201 in the first direction X. The two third exposed portions 203 are respectively located along the two sides of the nitride semiconductor light emitting element 1 extending in the second direction Y. The width of the fourth exposed portion 204 in the second direction Y can be made less than the width of the first exposed portion 201 in the second direction Y.

By achieving the positional relationship between the n-side semiconductor layer 20 and the p-side semiconductor layer 50 in the top view shown in FIG. 9 as described above, a highly reliable nitride semiconductor light emitting element which emits ultraviolet light can be provided.

The reason for this will be described below.

In a nitride semiconductor light emitting element having a quadrangular top view shape, because the active layer and the p-side semiconductor layer located above the active layer normally occupy a larger area, they are preferably disposed closely to the outline of the nitride semiconductor light emitting element. However, the present inventors found that, in a nitride semiconductor light emitting element which emits ultraviolet light, disposing the active layer and the p-side semiconductor layer close to the corners of the nitride semiconductor light emitting element can cause the heat generated during light emission to be concentrated in the corners to thereby reduce the reliability of the element.

The positional relationship between the n-side semiconductor layer 20 and the p-side semiconductor layer 50 in the top view shown in FIG. 9 is one that is based on the findings of the present inventors described above and made it possible to provide a highly reliable nitride semiconductor light emitting element that emits ultraviolet light.

In other words, the exposed portions of the n-side semiconductor layer 20 are arranged along all sides of the nitride semiconductor light emitting element such that the active layer 30 and the p-side semiconductor layer 50 are disposed inward of the exposed portions of the n-side semiconductor layer 20 in the top view. Not disposing the active layer and the p-side semiconductor layer near the four corners of the nitride semiconductor light emitting element can reduce the concentration of the heat generated during light emission at the corners, thereby improving the reliability of the light emitting element.

One example of an electrode structure in the case of the positional relationship between the n-side semiconductor layer 20 and the p-side semiconductor layer 50 shown in FIG. 9 will be explained below.

The n-electrode 60 includes an n-side electrode 61 and an n-side pad electrode 62. The p-electrode 70 includes a first p-side electrode 71, a second p-side electrode 72 disposed above the first n-side electrode 71, and a p-side pad electrode 73 disposed above the second p-side electrode 72. The n-side electrode 61 is positioned to overlap the first exposed portion 201, the second exposed portions 202, and the third exposed portions 203 in the top view. The n-side electrode 61 is disposed above the n-side contact layer 22 of the n-side semiconductor layer 20 and electrically connected to the n-side semiconductor layer 20. The first p-side electrode 71 is positioned to overlap the base portion 501 and the extended portions 502 of the p-side semiconductor layer 50 in the top view. The first p-side electrode 71 is disposed above the second p-side semiconductor layer 52 of the p-side semiconductor layer 50 and electrically connected to the p-side semiconductor layer 50. The first p-side electrode 71 is disposed above the upper face of the second p-side semiconductor layer 52. The second p-side electrode 72 is disposed above the upper face of the first p-side electrode 71. The p-side pad electrode 73 is disposed above a portion of the upper face of the second p-side electrode 72. The p-side pad electrode 73 has, for example, a base portion disposed practically above the entire surface of the second p-side electrode 72 located above the base portion 501 of the p-side semiconductor layer 50, and extended portions extending from the base portion along the extended portions 502 of the p-side semiconductor layer 50 as shown in FIG. 9. The n-side electrode 61 is disposed in contact with the exposed portions of the n-side semiconductor layer 20. The n-side pad electrode 62 is disposed above a portion of the upper face of the n-side electrode 61. The n-side pad electrode 62 includes a base portion positioned to overlap the first exposed portion 201 and extended portions extending from the base portion along the second exposed portions 202 in the top view.

As shown in FIG. 10, a protective film 80 is disposed to cover the semiconductor structure body 100 disposed above the substrate 10, the n-side electrode 61, the first p-side electrode 71, and the second p-side electrode 72. The protective film 80 has an opening 81 positioned above the n-side electrode 61 and an opening 82 positioned above the second p-side electrode 72. The n-side pad electrode 62 is connected to the n-side electrode 61 via the opening 81 of the protective film 80, and the p-side pad electrode 73 is connected to the second p-side electrode 72 via the opening 82 of the protective film 80. For the protective film 80, for example, SiO₂, SiON, or the like can be used. The thickness of the protective film 80 can be set, for example, in a range of 1 µm to 2 µm, for example.

For the n-side electrode 61, for example, metals, such as silver (Ag), Al, nickel (Ni), gold (Au), rhodium (Rh), titanium (Ti), platinum (Pt), molybdenum (Mo), tantalum (Ta), tungsten (W), and ruthenium (Ru), or alloys containing these metals as main components can be used. The n-side electrode 61 can be, for example, a multilayer structure that includes multiple metal layers. The n-side electrode 61 can be a multilayer structure including, successively from the n-side semiconductor layer 20 side, a Ti layer, an Al alloy layer, a Ta layer, and a Ru layer, for example.

For the n-side pad electrode 62, for example, metals, such as Ni, Au, Ti, Pt, and W, or alloys containing these metals as main components can be used. The n-side pad electrode 62 can be a multilayer structure including, successively from the n-side electrode 61 side, a Ti layer, a Pt layer, and an Au layer. The thickness of the n-side pad electrode 62 can be set, for example, in a range of 500 nm to 1500 nm.

For the p-electrode 70, for example, the same or similar metals to those for the n-electrode 60 described above can be used. The p-electrode 70 preferably reflects the light advancing from the active layer 30 to the p-electrode 70 towards the n-side semiconductor layer 20 and thus, for example, a metal having a high reflectance with respect to the light from the active layer 30 is preferably used for at leas one of the first p-side electrode 71 and the second p-side electrode 72. A metal having a high reflectance refers to, for example, a metal having a reflectance of 60% or higher with respect to the light from the active layer 30. For example, Rh or Ru is preferably used for at least one of the first p-side electrode 71 and the second p-side electrode 72.

In the case of using a layer containing Rh or Ru for the first p-side electrode 71, the first p-side electrode 71 preferably further includes an Au layer. This can enhance the adhesion between the first p-side electrode 71 and the p-side semiconductor layer 50 while maintaining a high reflectance as compared to a layer formed only of an Rh or Ru layer. The first p-side electrode 71 can be a multilayer structure including, successively from the p-side semiconductor layer 50 side, an Rh layer, an Au layer, and an Ni layer, or a multilayer structure including an Ru layer, an Au layer, and an Ni layer. Furthermore, the first p-side electrode 71 can be a layer that includes an alloy layer that contains Rh or Ru and contains Au and/or Ni.

For the p-side pad electrode 73, for example, the same or similar metals to those for the n-side pad electrode 62 described above can be used. The p-side pad electrode 73 can be a multilayer structure including, successively from the p-side semiconductor layer 50 side, a Ti layer, a Pt layer, and an Au layer, for example. The thickness of the p-side pad electrode 73 can be set, for example, in a range of 500 nm to 1500 nm.

A nitride semiconductor light emitting element in an Example will be explained below.

### EXAMPLE

As the substrate 10, a sapphire substrate having C-plane as a principal plane was used. An underlayer 11 formed of AlN was formed above the substrate 10 to a thickness of about 2.1 µm.

The temperature was then set at 1175°C, and an Al_{0.60}Ga_{0.40}N layer was formed above the underlayer 11 to a thickness of about 21 nm by using TMA gas, TMG gas, and ammonia gas as source gases. This was followed by forming an AIN layer at 1175°C to a thickness of about 10 nm by using TMA gas and ammonia gas as source gases. A superlattice layer 12 was formed by stacking 30 pairs of such AlGaN and AlN layers.

Then at 1175°C, an undoped layer 21 was formed above the superlattice layer 12 by growing Al_{0.60}Ga_{0.40}N to a thickness of about 0.5 µm by using TMA gas, TMG gas, and ammonia gas as source gases. This was followed by forming an n-side contact layer 22 at 1175°C by growing Al_{0.60}Ga_{0.40}N containing an n-type impurity to a thickness of about 2.2 µm by using TMA gas, TMG gas, ammonia gas, and SiH₄ gas as source gases. An n-side semiconductor layer 20 including such an undoped layer 21 and an n-side contact layer 22 was formed. The n-type impurity concentration of the n-side contact layer 22 was about 9.5 × 10¹⁸/cm³.

Subsequently, the temperature was set at 950°C and a first layer 31a was formed above the n-side semiconductor layer 20 by growing Al_{0.60}Ga_{0.40}N containing an n-type impurity to a thickness of about 40 nm by using TMA gas, TMG gas, ammonia gas, and SiH₄ gas as source gases. This was followed by forming a second layer 31b at 950°C by growing Al_{0.60}Ga_{0.40}N to a thickness of about 10 nm by using TMA gas, TMG gas, ammonia gas, and SiH₄ gas as source gases. Here, the flow rates of the source gases for forming the first layer 31a were set to: TMA gas 16 sccm, TEGa gas 45 sccm, ammonia gas 10 slm, and SiH₄ gas 0.5 sccm. The flow rates of the source gases for forming the second layer 31b were set to: TMA gas 16 sccm, TEGa gas 45 sccm, ammonia gas 10 slm, and SiH₄ gas 16 sccm.

In the manner described above, a first barrier layer 31 which included a first layer 31a containing an n-type impurity and a second layer 31b containing more n-type impurity than that in the first layer 31a was formed.

Furthermore, the thicknesses of the first layer 31 a and the second layer 31b here are the thicknesses in the manufacturing process, and do not necessarily match the thickness of the first layer 31a having a lower n-type impurity concentration than the average value of that of the entire first barrier layer 31 and the thickness of the second layer 31b having a higher n-type impurity concentration than the average value of that of the entire first barrier layer 31 identified after manufacturing the product.

Then a first well layer 32 was formed at 950°C by growing Al_{0.43}Ga_{0.57}N to a thickness of about 4.4 nm by using TMA gas, TEGa gas, and ammonia gas as source gases.

Subsequently, a second barrier layer 33 was formed by setting the temperature at 950°C and growing Al_{0.53}Ga_{0.47}N to a thickness of about 2.5 nm by using TMA gas, TEGa gas, and ammonia gas as source gases. This was followed by forming a second well layer 34 by growing Al_{0.47}Ga_{0.53}N to a thickness of about 2.2 nm at 950°C by using TMA gas, TEGa gas, and ammonia gas as source gases. In this manner, an active layer 30 which included two well layers and two barrier layers was formed.

Subsequently, the temperature was set at 870°C, and an AlN layer 41 was formed above the active layer 30 to a thickness of about 1.3 nm by using TMA gas and ammonia gas as source gases. This was followed by forming a first AlGaN layer 42 at 870°C by growing Al_{0.55}Ga_{0.45}N to a thickness of about 1.2 nm by using TMA gas, TEGa gas, and ammonia gas as source gases. This was followed by forming a second AlGaN layer 43 at 870°C by growing Al_{0.77}Ga_{0.22}N to a thickness of about 4 nm by using TMA gas, TEGa gas, and ammonia gas as source gases. In this manner, an electron blocking layer 40 which included an AlN layer and two AlGaN layers was formed.

Then the temperature was set at 870°C, and an Al_{0.63}Ga_{0.37}N layer containing a p-type impurity was formed above the electron blocking layer 40 to a thickness of about 75 nm by using TMA gas, TEGa gas, ammonia gas, and Cp₂Mg gas as source gases. This was followed by forming an Al_{0.53}Ga_{0.47}N layer containing a p-type impurity at 870°C to a thickness of about 27 nm by using TMA gas, TMG gas, ammonia gas, and Cp₂Mg gas as source gases. Then a gradient composition layer containing a p-type impurity was formed at 870°C to a thickness of about 3 nm by using TMA gas, TEGa gas, ammonia gas, and Cp₂Mg gas as source gases while gradually reducing the TMA gas such that the Al composition ratio gradually decreased from Al_{0.53}Ga_{0.47}N to ultimately 0. In the manner described above, a first p-side semiconductor layer 51 was formed.

This was followed by forming an Al_{0.40}Ga_{0.60}N layer containing a p-type impurity at 900°C to a thickness of about 10 nm by using TMA gas, TMG gas, ammonia gas, and Cp2Mg gas as source gases. Then a GaN layer containing a p-type impurity was formed at 900°C to a thickness of about 10 nm by using TMA gas, TMG gas, and ammonia gas as source gases. In the manner described above, a second p-side semiconductor layer 52 that included an Al_{0.40}Ga_{0.60}N layer containing a p-type impurity and a GaN layer containing a p-type impurity was formed.

Subsequent to forming each semiconductor layer, a heat treatment was conducted in a nitrogen atmosphere in the reaction chamber at a temperature of about 475°C.

Subsequent to the heat treatment, a portion of the p-side semiconductor layer 50 and a portion of the active layer 30 were removed to expose a portion of the n-side contact layer 22.

Then an n-electrode 60 was formed above the n-side contact layer 22, and a p-electrode 70 was formed above the p-side semiconductor layer 50. For the n-electrode 60, a multilayer structured electrode in which a Ti layer, AISi layer, a Ta layer, a Ru layer, and a Ti layer were stacked successively from the n-side contact layer 22 side was used. For the p-electrode 70, a multilayer structured electrode in which a Ti layer, a Ru layer, and a Ti layer were stacked successively from the third layer 53 side was used.

The forward volage of the nitride semiconductor light emitting element prepared as described above was 5.16 V, and the light emission output Po was 172 mW. The forward volage and the light emission output Po shown here are the values achieved when a 350 mA current was applied.

The position of the highest n-type impurity concentration peak in the first barrier layer 31 was in the second layer 31b. The highest peak value of the n-type impurity concentration in the first barrier layer 31 was about 3×10¹⁹/cm³.

The nitride semiconductor light emitting element according to the embodiments of the present disclosure includes the following.

## Claims

1. A nitride semiconductor light emitting element comprising:
an n-side semiconductor layer;
a p-side semiconductor layer; and
an active layer positioned between the n-side semiconductor layer and the p-side semiconductor layer; wherein:
the active layer comprises, successively from a n-side semiconductor layer side:
a first barrier layer containing Al and an n-type impurity,
a first well layer containing Al and emitting ultraviolet light,
a second barrier layer containing Al, and
a second well layer containing Al and emitting ultraviolet light;
a highest n-type impurity concentration peak in the first barrier layer is located in a portion of the first barrier layer that is closer to the p-side semiconductor layer than to the n-side semiconductor layer; and
an Al composition ratio of the first barrier layer is higher than an Al composition ratio of the second barrier layer.

2. The nitride semiconductor light emitting element according to claim 1, wherein:
the first barrier layer comprises:
a first layer that contains an n-type impurity at a concentration lower than an average value of an n-type impurity concentration of an entirety of the first barrier layer, and
a second layer that is located closer to the p-side semiconductor layer than is the first layer, contains an n-type impurity at a concentration higher than the average value of the n-type impurity concentration of the entirety of the first barrier layer, and has a thickness less than a thickness of the first layer.

3. The nitride semiconductor light emitting element according to claim 2 wherein:
the thickness of the second layer is in a range of 5% to 30% of a total thickness of the first barrier layer.

4. The nitride semiconductor light emitting element according to claim 2 or 3 wherein:
a thickness of the second barrier layer is less than the thickness of the second layer.

5. The nitride semiconductor light emitting element according to any one of claims 2 to 4 wherein:
the second barrier layer contains an n-type impurity at a concentration lower than the n-type impurity concentration of the second layer and higher than the n-type impurity concentration of the first layer.

6. The nitride semiconductor light emitting element according to any one of claims 2 to 5 wherein:
the Al composition ratio of the first layer and the Al composition ratio of the second layer are substantially the same.

7. The nitride semiconductor light emitting element according to any one of claims 1 to 6 wherein:
the first barrier layer is in contact with the n-side semiconductor layer; and
the Al composition ratio of the first barrier layer and the Al composition ratio of the n-side semiconductor layer are substantially the same.

8. The nitride semiconductor light emitting element according to any one of claims 2 to 6 wherein:
the n-side semiconductor layer comprises an n-side contact layer in contact with the first barrier layer; and
an n-type impurity concentration of the n-side contact layer is lower than the n-type impurity concentration of the second layer and higher than the n-type impurity concentration of the first layer.

9. The nitride semiconductor light emitting element according to any one of claims 1 to 8 wherein:
a thickness of the second well layer is less than a thickness of the first well layer.

10. The nitride semiconductor light emitting element according to any one of claims 1 to 9 wherein:
an Al composition ratio of the second well layer is higher than an Al composition ratio of the first well layer.

11. A method of manufacturing a nitride semiconductor light emitting element, the method comprising:
forming an n-side semiconductor layer;
forming an active layer above the n-side semiconductor layer by performing steps comprising:
forming, above the n-side semiconductor layer, a first barrier layer by growing a first layer containing Al and an n-type impurity followed by growing, above the first layer, a second layer containing Al and an n-type impurity, wherein an n-type impurity concentration of the second layer is higher than an n-type impurity concentration of the first layer,
forming, above the first barrier layer, a first well layer that contains Al and emits ultraviolet light,
forming, above the first well layer, a second barrier layer that contains Al and an n-type impurity, wherein an Al composition ratio of the second barrier layer is lower than both an Al composition ratio of the first layer and an Al composition ratio of the second layer, and
forming, above the second barrier layer, a second well layer that contains Al and emits ultraviolet light; and
forming a p-side semiconductor layer above the active layer.

12. The method of manufacturing a nitride semiconductor light emitting element according to claim 11, wherein:
a thickness of the second layer is less than a thickness of the first layer.

13. The method of manufacturing a nitride semiconductor light emitting element according to claim 12, wherein:
a thickness of the second layer is in a range of 5% to 30% of a total thickness of the first barrier layer.

14. The method of manufacturing a nitride semiconductor light emitting element according to claim 11 or 12, wherein:
a thickness of the second barrier layer is less than a thickness of the second layer.

15. The method of manufacturing a nitride semiconductor light emitting element according to any one of claims 11 to 14, wherein:
an n-type impurity concentration of the second layer is lower than the n-type impurity concentration of the second layer and higher than the n-type impurity concentration of the first layer.

16. The method of manufacturing a nitride semiconductor light emitting element according to any one of claims 11 to 15, wherein:
the Al composition ratio of the first layer and the Al composition ratio of the second layer are substantially the same.

17. The method of manufacturing a nitride semiconductor light emitting element according to claim 16, wherein:
the Al composition ratio of the first barrier layer and the Al composition ratio of the n-side semiconductor layer are substantially the same.

18. The method of manufacturing a nitride semiconductor light emitting element according to any one of claims 11 to 17, wherein:
the step of forming an n-side semiconductor layer comprises forming an n-side contact layer;
in the step of forming an active layer, the first barrier layer is formed in contact with the n-side contact layer; and
the n-type impurity concentration of the first layer is lower than an n-type impurity concentration of the n-side contact layer; and
the n-type impurity concentration of the second layer is higher than the n-type impurity concentration of the n-side contact layer.

19. The method of manufacturing a nitride semiconductor light emitting element according to any one of claim 11 to 18, wherein:
the thickness of the second well layer is less than a thickness of the first well layer.

20. The method of manufacturing a nitride semiconductor light emitting element according to any one of claim 11 to 19, wherein:
an Al composition ratio of the second well layer is higher than the Al composition ratio of the first well layer.
